# EUROPEAN PATENT APPLICATION

(11) **EP 3 594 631 A1**
(43) Date of publication of application: **15.01.2020**
(21) Application number: 18182738.7
(22) Date of filing: 10.07.2018
(51) Int. Cl.: G01D 9/00, G01D 11/24, G01D 21/00

(54) **AUTONOMOUS DATA LOGGER**

(71) Applicant: CSEM Centre Suisse d'Electronique et de Microtechnique SA, 2002 Neuchâtel (CH)
(72) Inventor: Nussbaum, Pascal, 2052 Fontainemelon (CH); Blanc, Sébastien, 1007 Lausanne (CH); Dominé, Didier, 2503 Bienne (CH); Favre, Elisa, 74350 Cuvat (FR); Cattaneo, Gianluca, 2000 Neuchâtel (CH)
(74) Representative: P&TS SA (AG, Ltd.)

(57) **Abstract**

An autonomous data logger (1) for acquiring and storing sensor data from a sensor, said data logger comprising: a harvesting device (20) comprising a power source module (21), the harvesting device (20) being embedded in a encapsulating layer (22) and comprising a receiving area (23); a sensing device (10) comprising a sensor module (11) for acquiring sensor data and configured to be received in the receiving area (23) of the harvesting device (20); the receiving area (23) comprising a first coupling element (30) and the sensing device (10) comprising a second coupling element (31); said first and second coupling elements (30, 31) being configured to provide attachment means and electrical connection means between the sensing device (10) and the harvesting device (20) such that, when the sensing device (10) is received in the receiving area (23), the sensing device (10) is fixed to the harvesting device (20) and is powered by the power source module (21).

## Description

### Field

The present invention concerns autonomous data logger for acquiring and storing sensor data from a sensor and comprising a harvesting device and a sensing device.

### Background

Data loggers are electronic devices that records data over time or in relation to location either with a built in instrument or sensor or via external instruments and sensors. Existing data loggers make use of a digital processor (or computer) which provide sensor data acquisition and store acquired data. In the case the data loggers comprises an imaging sensor (such as a camera), the acquired data can be based on activity, or motion, detection.

Existing data loggers, however, suffer either from limited operations autonomy or from high bulkiness and cost.

### Summary

The present disclosure concerns an autonomous data logger for acquiring and storing sensor data from a sensor, said data logger comprising: a harvesting device comprising a power source module, the harvesting device being embedded in a encapsulating layer and comprising a receiving area; a sensing device comprising a sensor module for acquiring sensor data and configured to be received in the receiving area of the harvesting device; the receiving area comprising a first coupling element and the sensing device comprising a second coupling element; said first and second coupling elements being configured to provide attachment means and electrical connection means between the sensing device and the harvesting device such that, when the sensing device is received in the receiving area, the sensing device is fixed to the harvesting device and is powered by the power source module.

The present disclosure further concerns system comprising a host computer docking station configured to receive the sensing device, the host computer docking station providing communication between the sensing device and the docking station when the data logger is received in the host computer docking station, and between the host computer docking station and an external computing means when the data logger.

The docking station can be configured to allow a user to perform various actions on the sensing device including configuration operations, download a memory content, erase the memory, charge a battery and update a firmware.

The data logger has the capability to integrate an autonomous sensor logger in the form factor of a palm-sized, or smaller, sticker. The sensor device can comprise one or a plurality of sensors powered by the harvesting device. The data logger has a very small form factor and allows for various shape designs. The data logger can be low-power and fully autonomous, requiring no battery.

### Brief Description of the Drawings

The invention will be better understood with the aid of the description of an embodiment given by way of example and illustrated by the figures, in which:
Figs. 1a and 1b show a cross section view (Fig. 1a), a top view (Fig an autonomous data logger 1 comprising a sensing device and a harvesting device, according to an embodiment;
Fig. 1c shows a detailed top view of the sensing device, according to an embodiment;
Fig 2 shows a cross section view of the harvesting device, according to an embodiment;
Figs. 3a to 3c show the sensing device according to an embodiment;
Fig. 4 represents a front view of the harvesting device, according to an embodiment;
Fig. 5 shows a cross section view of the harvesting device, according to another embodiment;
Figs. 6a and 6b show an exploded back side (Fig. 6b) and front side (Fig. 6b) view of the sensing device, according to an embodiment;
Figs. 7a and 7b show a front side view (Fig. 7a) and a back side view (Fig. 7b) of the sensing device, according to an embodiment;
Figs. 8a and 8b illustrate a system comprising host computer docking station configured to receive the sensing device, according to an embodiment;
Figs. 9a and 9b show a possible square-shaped configuration of the flexible harvesting device; and
Fig. 10 illustrates different possible shapes of the harvesting device.

### Detailed Description of possible embodiments

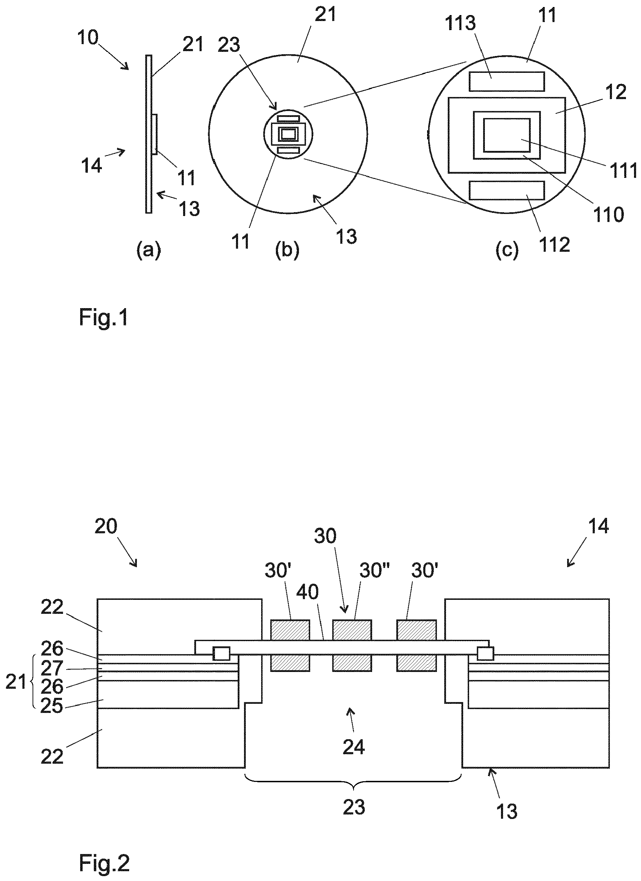

**Figs. 1a** and **1b** show a cross section view (Fig. 1a), a top view (Fig an autonomous data logger 1 comprising a sensing device 10 and a harvesting device 20, according to an embodiment. **Fig. 1c** shows a detailed top view of a possible arrangement of the sensing device 10. The sensing device 10 comprises a sensor module 11 for acquiring sensor data. The harvesting device 20 comprises a power source module 21. The harvesting device 20 is configured to be assembled to the sensing device 10 such that the harvesting device 20 can power the sensing device 10 when they are assembled.

**Fig. 2** shows a cross section view of the harvesting device 20, according to an embodiment. The power source module of the harvesting device 20 comprises a photovoltaic solar cell 21. The photovoltaic solar cell 21 can be bonded with two layers of adhesive film, commonly referred as the encapsulant (or encapsulating layer). The encapsulating layer 22 is preferably based on ethyl vinyl acetate (EVA). The thickness of the EVA encapsulating layer 22 can be about 200 µm. The encapsulating layer 22 can further comprise a layer of ethylene-tetra-fluoro-ethylene (ETFE), for example having a thickness of about 50 µm.

The photovoltaic solar cell 21 can be made of a crystalline or a hydrogenated amorphous silicon solar cell (a-Si:H) layer 27 coated with a transparent conductive oxide (TCO) layer 26 on both faces. Preferably, the photovoltaic solar cell 21 is supported on a flexible substrate 25 such that the harvesting device 20 is also flexible. To that end, the flexible substrate 25 can comprise a polyethylene naphthalate (PEN) layer. The PEN layer can have a rigidity that can be less than 12 x 10⁻⁴ Nm. The flexible substrate 25 can have a bending radius of 5 cm or smaller. Thus, the flexible substrate 25 is flexible enough to be conformable to non-planar surface. The thickness of the harvesting device 20 comprising the photovoltaic solar cell 21, the TCO layers 26 and the flexible PEN substrate layer 25 and the encapsulating layer 22 can be between 500 µm and 650 µm. The harvesting device 20 has a bending radius of 5 cm or smaller. The photovoltaic solar cell 21 can be configured to deliver 2 mW at 1kLux, or more.

In other embodiments, the power source module 21 can comprise any other type of power generating device. For example, the power source module 21 can comprise a thermoelectric energy harvesting (TEG) device, a piezoelectric device for vibration energy harvesting, a primary cell, magnetic induction harvesting device, or a USB docking station.

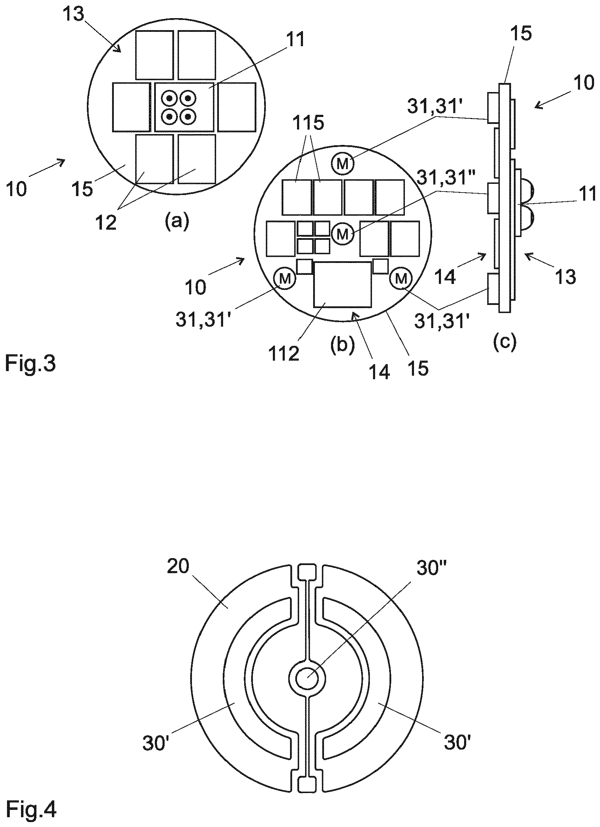

**Figs. 3a** to **3c** show the sensing device 10 according to an embodiment. In particular, Fig. 3a shows a front side 13 of the sensing device 10 comprising the sensor module 11, Fig. 3b shows a back side 14 of the sensing device 10 comprising the second coupling element 31, and Fig. 3c shows a cross section view of the sensing device 10 including the sensing module 11.

In the embodiment of Fig. 3, the sensing module 11 comprises a imaging device 110 and an collimating optical module 111. The imaging device 11 can comprise in a non-limiting way micro-cameras, light-weight vision systems, and similar devices comprising image sensors. Preferably, the imaging device 110 can comprise an image sensor comprising an innovative micro-optical component such as described in patent application EP20180182654.6 by the present applicant, wherein the micro-optical component is connected to ultra-thin or very flat optical components, so as to obtain an optic height in the order of few millimeters, typically about 2 mm.

In the case the sensor device 11 is a imaging device, the data logger 1 can be advantageously used for surveillance by image capture. The combination of the thin imaging device 110, collimating optical module 111 and the photovoltaic solar cell 21 allows for the data logger 1 to have a form factor such as a palm-sized or smaller sticker. The imaging sensor 11 can further use an ultra-low power pixel circuit such as described in patent application EP18182685.0 by the present applicant, enabling the data logger 1 to have an extended autonomy.

Referring to Fig. 1c and Figs. 3a to 3c, the sensing module 11 can further comprise a circuitry (for example an ASIC) 15 including a memory 12 for storing acquired sensor data, a processor module 112 for processing the acquired sensor data, a wireless link 113 for transmitting the processed sensor data to a remote device, a harvester 114 (for example a battery) for gathering at least some of the power generated by the power source module 21 and capacitive elements 115.

In other embodiments, the sensing module 11 can comprise any other type of sensor or device. For example, the sensing module 11 can comprise sensors for temperature, humidity, air quality, light level, vibrations, sound pressure, etc. The sensing module 11 can comprise a plurality of sensors powered by the harvesting device.

The harvesting device 20 comprises a receiving area 23 configured to receive the sensing device 10 when the latter is assembled with the harvesting device 20. The receiving area 23 comprises a first coupling element 30 destined to cooperate with a second coupling element 31 comprised on the sensing device 10. When cooperating, the first and second coupling elements 30, 31 provide a removable attachment between the harvesting device 20 and the sensing device 10. The cooperating first and second coupling elements 30, 31 also an electrical connection, allowing the sensing device 10 to be powered by the harvesting device 20.

In the example illustrated in Figs. 1 to 3, the harvesting device 20 and the sensing device 10 are disk-shaped. The receiving area 23 is shown concentric to the harvesting device 20 but could be disposed off-center.

In the exemplary configuration of Fig. 2, the receiving area 23 comprises a PCB element 40. The PCB element 40 comprises the first coupling element 30 and can be mounted on harvesting device 20 such as to provide electrical contact between the first coupling element 30 and the power source module 21. The electrical contact can be provided by using a conducting paste, such as silver paste, or any other electrical contacting means.

**Fig. 4** represents a possible configuration of the first coupling element 30 comprising an annular-shaped peripheral first coupling element 30' and a disk-shaped central first coupling element 30". As shown in Figs. 2b and 2c, the sensing device 10 can comprise three peripheral disk-shaped second coupling elements 31' destined to contact the first coupling element 30', and a disk-shaped central second coupling element 31" disposed concentric on the sensing device 10, destined to contact the central first coupling element 30", when the sensing device 10 is assembled with the harvesting device 20.

The first and second coupling element 30, 31 can comprise an electrically conductive and magnetic element. When the first coupling element 30 cooperates with a second coupling element, the electrically conductive and magnetic element provides magnetic attraction between the first and second coupling element 30, 31, achieving magnetic attachment therebetween. The electrically conductive and magnetic element further provides a good electrical contact between the first and second coupling element 30, 31 when in contact.

The electrically conductive and magnetic element can comprise a composite structure including a mixture of a magnetic material and an electrically conductive material. The electrically conductive and magnetic element can comprise a magnetic material embedded in an electrically conductive material, such that the electrically conductive material of the first coupling element 30 contacts the electrically conductive material of the second coupling element 31 when the harvesting device 20 is assembled to the sensing device 10.

The magnetic material can comprise any metal with good magnetic permeability, such as iron (pure iron), carbon steel (not stainless), nickel, permalloy, cobalt-iron alloy, nickel-iron soft ferromagnetic alloy (such as Mu-metal®), cobalt-based alloy (such as Metglas® 2714A).

The electrically conductive material can comprise any metal providing high electrical conductivity and good resistance to corrosion, such as Ni, Cr, Pd, Pt, Au or an alloy of these metals.

In other embodiments, one the first and second coupling element 30, 31 can comprise a magnetic material and the other coupling element 30, 31 comprises a ferromagnetic material. Preferably, the first coupling element 31 comprises a ferromagnetic material and the second coupling element 31 comprises a magnetic material.

In yet other embodiments, each of the first and second coupling element 30, 31 can comprises a portion that provides magnetic attraction and another portion that provides electrical contact. Referring to Figs. 2 to 4, the magnetic attraction can be provided between the central first and second coupling elements 30", 31" and the electrical contact can be provided between the peripheral first and second coupling elements 30', 31'.

Other arrangements of the first and second coupling elements 30, 31 are also possible. For example, the sensing device 10 can comprise less or more than three peripheral disk-shaped second coupling elements 31. The peripheral disk-shaped second coupling elements 31 can be merged in an annular segment destined to cooperate with the annular segment 30'.

More generally, the receiving area 23 can comprise a plurality of the first coupling element 30 and the sensing device 10 comprises a plurality of the second coupling element 31, wherein each of the first coupling elements 30 cooperates with one of the second coupling elements 31 when the harvesting device 20 is assembled to the sensing device 10.

The first coupling element 30 can be disposed either side 13, 14 PCB element 40 (as shown in Fig. 2) or on only one side13, 14.

The encapsulating layer 22 can be configured mechanical attachment of the harvesting device 20 on a surface. This can be achieved by making the encapsulating layer 22 adhesive. For example, the encapsulating layer 22 can comprise a pressure sensitive adhesive layer. The pressure sensitive adhesive layer is not visible in the figures because it is part of the encapsulating layer 22. In other words, the sensitive adhesive layer is integrated to the encapsulating layer 22 when the latter is manufactured. The pressure sensitive adhesive layer could also be a separate layer on top of the encapsulating layer 22. The pressure sensitive adhesive layer can have a thickness between 20 and 30 µm or about 25 µm. The encapsulating layer 22 can also be made adhesive by using a non-permanent adhesive.

Referring to Fig. 1 wherein the power source module comprises a photovoltaic solar cell 21, the active surface of the photovoltaic solar cell 21 can be on the front side 13. In this configuration, the harvesting device 20can be made adhesive on the back side 14. The back side 14 of the harvesting device 20 can thus be attached to a possibly opaque surface. The sensing device 10 is assembled on the front side 13 of the harvesting device 20. In such configuration, the unobstructed active surface of the photovoltaic solar cell 21 on the front side 13 and around the sensing device 10 can collect available light. The sensing device 10 is also unobstructed. In another possible configuration, the active surface of the photovoltaic solar cell 21 can be on the back side 14 being also made adhesive. The back side 14 of the harvesting device 20 can then be fixed on a semi-transparent or transparent surface (such as a window) allowing the whole surface of the photovoltaic solar cell 21 to collect light.

The data logger 1 comprising the sensing device 10 assembled on the harvesting device 20 can thus be attached to any surface such as a wall or a window.

The harvesting device 20 can be less than 100 mm in diameter and less than 1 mm in thickness. The sensing module 11 comprising the imaging device 110 and the image sensor 111 configured as the innovative micro-optical component described above, the data logger 1 can be as thin as 2 mm.

In such configuration, the data logger 1 that take the form of a flexible palm-sized adhesive sticker combining the solar cell 21 and the solar cell powered image sensor 100, 111 (camera).

In an embodiment, the receiving area 23 comprises a recess 24 (see Fig. 2). The recess 24 can be configured such that the sensing device 10 can be fitted within when assembled to the harvesting device 20. This arrangement allows for diminishing the total thickness of the data logger 1.

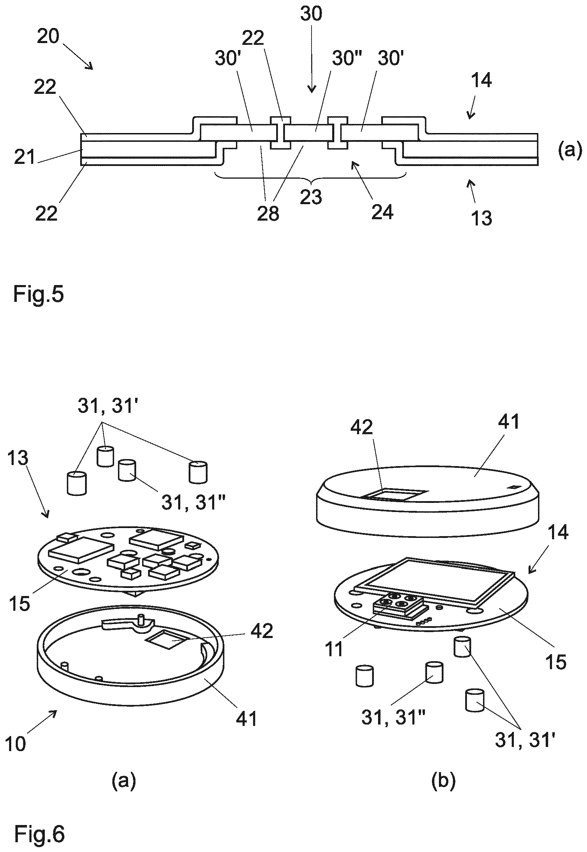

**Fig. 5** shows a cross section view of the harvesting device 20, according to another embodiment, wherein the encapsulating layer 22 extends within the receiving area 23 and wherein the first coupling element 30 is included in the extending encapsulating layer 22. In the particular example of Fig. 5, the first coupling element 30 comprises an annular-shaped peripheral first coupling element 30' and a disk-shaped central first coupling element 30" such as in the configuration of Fig. 4. The encapsulating layer 22 is provided with contact openings 28 in order to allows the peripheral first coupling element 30' and central first coupling element 30" to contact the second coupling element 31 when the sensing device 10 is assembled with the harvesting device 20. In a possible embodiment, the peripheral first coupling element 30' can be electrically conductive while the central first coupling element 30" provides magnetic attraction. In Fig. 5, the peripheral first coupling element 30' contacts a portion of the photovoltaic solar cell 21.

The receiving area 23 can further comprise a recess 24 configured to fit the sensing device 10. This configuration of the receiving area 23 can be significantly thinner than the configuration suing the PCB element 40, and the total thickness of the data logger 1 can be further decreased.

For example, the data logger 1 can have a thickness that is less than 1 mm. Such a data logger 1 having a diameter of between 60 and 80 mm and 0.6mm in thickness has been produced (without adhesive layer). The harvesting device 20 can deliver a power of up to 2.55 mW at 1 kLux. The production of a data logger 1 having a thickness as low as 0.2 mm and a diameter being less than 80 mm is currently under way.

In an embodiment, the ratio of the diameter (or lateral dimension) of the harvesting device 20 over the thickness of the data logger 1 (combined thickness of the harvesting device 20 and the sensing device) can be between 30 and 100.

**Figs. 6a** and **6b** show an exploded back side (Fig. 6b) and front side (Fig. 6b) view of the sensing device, according to an embodiment. The button-shaped sensing device 10 comprise a casing 41 enclosing the circuitry 15. A window 42 is provided in the casing 41 on the front side 13 for the sensor module 11 (here the collimating optical module of the imaging device sensor module). The peripheral and central second coupling elements 31', 31" are also visible.

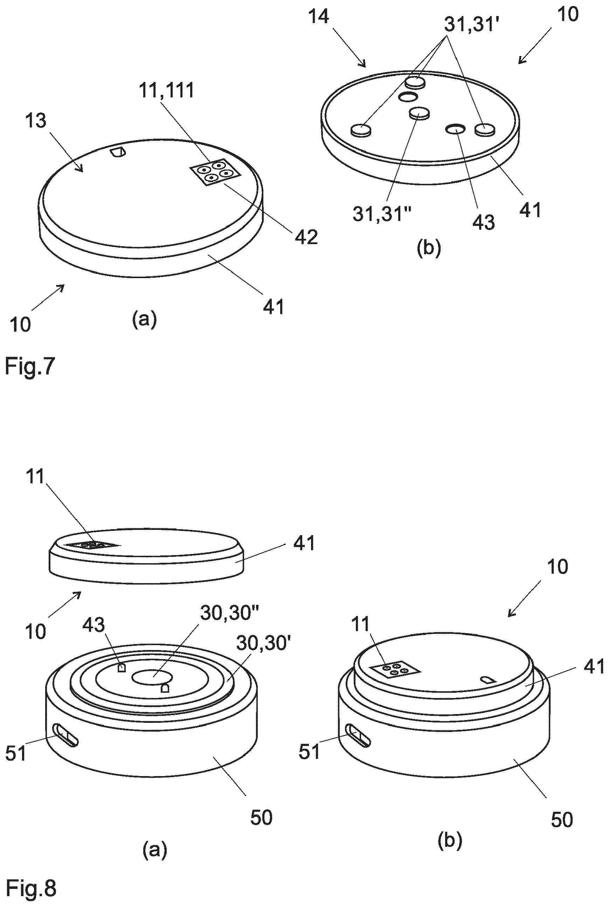

**Figs. 7a** and **7b** show a front side view (Fig. 7a) and a back side view (Fig. 7b) of the sensing device 10 of Fig. 6 when closed. The collimating optical module 111 of the imaging device sensor module 11 appear through the window 42 provided in the casing 41. The peripheral and central second coupling elements 31', 31" protrude on the back side 14 of the sensing device 10.

The sensor device 10 is capable to communicate with external devices, for example through BLE and/or wired serial data connection (UART).

In an possible configuration of the data logger 1, the sensing device 10 is formed integral with the harvesting device 20.

**Figs. 8a** and **8b** illustrate a system comprising host computer docking station 50 configured to receive the sensing device 10, according to an embodiment. In Fig. 8a, the sensing device 10 is shown separated from the docking station 50. The docking station 50 comprises a first coupling element 30 configured to cooperate with the second coupling element 31 of the sensing device 10. The first coupling element 30 on the docking station 50 should be compatible with the second coupling element 31 and thus can be configured as the first coupling element 30 provided on the harvesting device 20. In the example of Fig. 8a, the first coupling element 30 the annular segment 30' and the central disk 30". In Fig. 8b, the sensing device 10 is shown mounted on the docking station 50. Electrical contacts 43 are provided on the sensing device (see Fig. 7b) and the docking station 50.

The docking station 50 can be configured to provide wired connection via a wiring port 51 between the sensing device 10 external computing means (not shown) when the data logger 1 is received in the docking station 50.

The docking station 50 can be configured to allow a user to perform various actions on the sensing device 10 such as configuration operations (including: various settings, identification, etc.), downloading of the memory 12 content, erasing the memory 12 content, charging the battery 114 and updating firmware.

It is understood that the present invention is not limited to the exemplary embodiments described above and other examples of implementations are also possible within the scope of the patent claims.

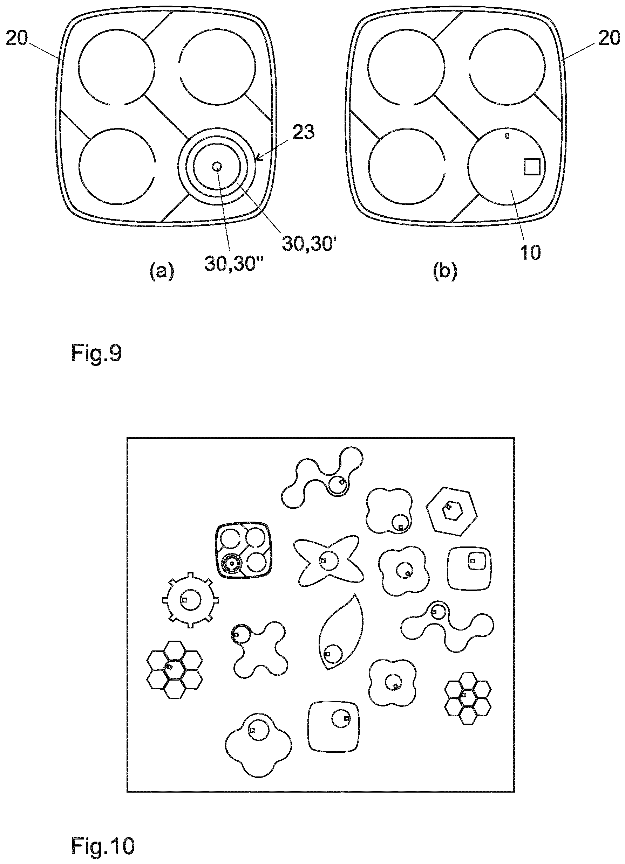

**Figs. 9a** and **9b** show a possible square-shaped configuration of the flexible harvesting device 20. The receiving area 23 is comprised in one off-center portion of the harvesting device 20. In this particular configuration, the first coupling element 30 comprises the annular segment 30' and the central disk 30".

The configuration of the harvesting device 20 is not limited to the circular and square shape but can have any other shapes as illustrated in **Fig. 10****.**

### Reference numbers

- 1: autonomous data logger
- 10: sensing device
- 11: sensor module
- 110: image sensor
- 111: optical module
- 112: processor module
- 113: wireless link
- 114: harvester
- 115: capacitive element
- 12: memory
- 13: front side face
- 14: back side face
- 15: circuitry
- 20: harvesting device
- 21: power source module
- 22: encapsulating layer
- 23: receiving area
- 24: recess
- 25: flexible substrate
- 26: transparent conductive oxide layer
- 27: solar cell layer
- 28: contact opening
- 30: first coupling element
- 30': peripheral first coupling element
- 30": central first coupling element
- 31: second coupling element
- 31': peripheral second coupling element
- 31": central second coupling element
- 40: PCB element
- 41: casing
- 42: window
- 43: electrical contacts
- 50: docking station
- 51: wiring port

## Claims

1. An autonomous data logger (1) for acquiring and storing sensor data from a sensor, said data logger comprising:
a harvesting device (20) comprising a power source module (21), the harvesting device (20) being embedded in a encapsulating layer (22) and comprising a receiving area (23);
a sensing device (10) comprising a sensor module (11) for acquiring sensor data and configured to be received in the receiving area (23) of the harvesting device (20);
the receiving area (23) comprising a first coupling element (30) and the sensing device (10) comprising a second coupling element (31);
said first and second coupling elements (30, 31) being configured to provide attachment means and electrical connection means between the sensing device (10) and the harvesting device (20) such that, when the sensing device (10) is received in the receiving area (23), the sensing device (10) is fixed to the harvesting device (20) and is powered by the power source module (21).

2. The data logger according to claim 1,
wherein the harvesting device (20) has a ratio of its lateral dimension, extending in a plane, over its thickness, perpendicular to the plane, being between 30 and 100.

3. The data logger according to claim 1 or 2,
wherein the harvesting device (20) has a thickness between 500 µm and 650 µm and a has a bending radius of 5 cm or smaller.

4. The data logger according to any one of claims 1 to 3,
wherein at least a portion of the encapsulating layer (22) is made adhesive allowing the harvesting device (20) to be fixed on a surface.

5. The data logger according to claim 4,
wherein the adhesive portion is on a back side (14) of the harvesting device (20), the receiving area (23) being on a front side (13) opposed to the back side (14).

6. The data logger according to any one of claims 1 to 5,
wherein the first and second coupling element (30, 31) comprises an electrically conductive and magnetically permeable element such that the fixation means is provided by magnetic attraction.

7. The data logger according to claim 6,
wherein the first and second coupling element (30, 31) comprises a magnetically permeable material and an electrically conductive material.

8. The data logger according to claim 7,
wherein the magnetic material comprises one of pure iron, cobalt-iron alloy, carbon steel, nickel, permalloy, nickel-iron soft ferromagnetic alloy, cobalt-based alloy.

9. The data logger according to claim 7 or 8,
wherein the electrically conductive material comprises one of Ni, Cr, Pd, Pt, Au or an alloy of these metals.

10. The data logger according to claim 6,
wherein one the first and second coupling element (30, 31) comprises a magnetic material and the other coupling element (30, 31) comprises a ferromagnetic material.

11. The data logger according to claim 10,
wherein the first coupling element (31) comprises a ferromagnetic material and the second coupling element (31) comprises a magnetic material.

12. The data logger according to any one of claims 1 to 11,
wherein the first coupling element (30) comprises a peripheral first coupling element (30') and a central first coupling element (30"); and wherein the second coupling element (31) comprises a peripheral second coupling element (31') and a central second coupling element (31").

13. The data logger according to claims 6 and 12,
wherein the central first and second coupling elements (30", 31") comprises a magnetic material and the peripheral first and second coupling elements (30', 31') provide electrical connection.

14. The data logger according to any one of claims 1 to 13,
wherein the receiving area (23) comprises a PCB element (40) comprising the first coupling element (30).

15. The data logger according to any one of claims 1 to 13,
wherein the encapsulating layer (22) extends within the receiving area (23); and
wherein the first coupling element (30) is included in the extending encapsulating layer (22).

16. The data logger according to any one of claims 1 to 15,
wherein the receiving area (23) comprises a recess (24) configured such that the sensing device (10) can be fitted within the recess (24) when received the receiving area (23).

17. The data logger according to any one of claims 1 to 16,
wherein the power source module (21) comprises a photovoltaic solar cell.

18. The data logger according to claim 17,
wherein photovoltaic solar cell (21) comprises a flexible substrate having a bending radius of 5 cm or smaller.

19. The data logger according to any one of claims 1 to 18,
wherein the sensor module (11) comprises an image sensor (110) and an collimating optical module (111).
